# EUROPEAN PATENT APPLICATION

(11) **EP 4 102 577 A1**
(43) Date of publication of application: **14.12.2022**
(21) Application number: 21178533.2
(22) Date of filing: 09.06.2021
(51) Int. Cl.: H01L 31/048, H01L 31/05

(54) **IMPROVED PARALLEL SOLAR CELL STRING ASSEMBLIES FOR USE IN A PHOTOVOLTAIC MODULE**

(71) Applicant: Meyer Burger (Switzerland) AG, 3645 Gwatt/Thun (CH)
(72) Inventor: Hänni, Simon, 3604 Thun (CH); Strahm, Benjamin, 1429 Giez (CH); Papet, Pierre, 2068 Hauterive (CH)
(74) Representative: Kasche & Partner

(57) **Abstract**

The present invention is directed to solar cell string assemblies with strings of solar cells with electrically conducting interconnect(s) in string direction, and with a flat adhesive(s), optionally a foil, for adhesively attaching the interconnect(s) to the solar cells positioned adjacent or shingled in string direction, wherein this adhesive extends to at least one solar cell of at least one parallel solar cell string for mechanically bridging and connecting parallel solar cell strings, wherein the solar cells in parallel connected solar cell strings do not have electrically conductive contact. The invention further pertains to photovoltaic modules comprising these parallel solar cell string assemblies.

## Description

The present invention is directed to solar cell string assemblies with strings of solar cells with electrically conducting interconnect(s) in string direction, and with a flat adhesive(s), optionally a foil, for adhesively attaching the interconnect(s) to the solar cells positioned adjacent or shingled in string direction, wherein this adhesive extends to at least one solar cell of at least one parallel solar cell string for mechanically bridging and connecting parallel solar cell strings, wherein the solar cells in parallel connected solar cell strings do not have electrically conductive contact. The invention further pertains to photovoltaic modules comprising these parallel solar cell string assemblies.

Typically, a photovoltaic module is assembled from a number of individually produced and separately transported solar cell strings, i.e. solar panels, and the strings are arranged side by side to form one large flat body. The solar cells of the string are electrically interconnected by wires or ribbons that connect the electrode side of one cell with the electrode side of the adjacent cell, thus allowing for current flow in string direction. Solar cell strings with solar cells arranged in parallel regularly feature a front-front configuration, where all front sides of the cells have the same electrode charge and the wire or ribbon will connect the front electrode of one cell with the rear electrode of opposite charge of the adjacent cell for serial connectivity. Alternatively, solar cells arranged in parallel may also feature a front-back configuration, where adjacent cells along the string direction have top and bottom sides facing each other in opposite polarity and the wire or ribbon establishes serial connectivity. A further option for solar strings is a front-front configuration with back contact energy conversion, e.g. "interdigitated back contact" (IBC) solar cells, where the entire front of the solar cell absorbs sunlight without shading from wires or ribbons. Most common interconnection schemes feature a certain gap between neighboring cells to enable the guidance of an interconnector from one side (one polarity) of one cell to the other side (opposite polarity) of the connected cell.

In an alternative way the solar cells can be connected by a slight overlap and thus allowing direct conductive contact of adjacent cells.

Overlapping shingled solar cell strings do not need conventional wire or ribbon interconnectors because of the close proximity of oppositely charges cell electrodes. Mechanical and conductive contact is routinely achieved by adding low resistance electrically conductive interconnect materials such as conductive adhesive alloys. The metallization interconnect is often rather thick to improve current flow. Since the gap for electrical insulation between front-front-arranged solar cells is no longer required, the shingled front-rear-arranged solar cells and the solar cell string can be dimensioned smaller giving the opportunity to achieve higher module efficiencies

However, mechanical stress on the interconnect in the overlap of shingled solar cells has the potential for (micro)cracks, possibly leading to reduced current flow or even short-circuiting of the electrons due to thermo-mechanical stress. A further disadvantage of solar cell shingling with direct contact in the overlapping zone is the relatively large overlap, necessary to guarantee a good contact and hence that the overlap part is no longer available for current formation.

WO2019/016118A1 discloses solar cell strings comprising (i) a string of solar cells shingled in string direction resulting in positive and negative electrode overlap, (ii) an interconnect for electrically connecting the positive and negative electrodes of the shingled solar cells, and (iii) an adhesive foil spanning at least part of the string and positioned on (a) the top (sun facing) sides of the at least two shingled solar cells, and/or (b) the bottom (far) sides of the at least two shingled solar cells, or on (c) the top side of one solar cell and on the bottom side of the overlapping solar cell, in which case the adhesive foil comprises the interconnect and connects the overlap in order to mechanically connect and position the shingled solar cells.

US Patent 7,432,438 B2 relates to an electrode for contacting an electrically conductive surface of a photovoltaic element, the electrode comprising an electrically insulating optically transparent film, an adhesive layer provided on a planar surface of the film, and a plurality of substantially parallel, electrically conductive wires embedded into the adhesive layer, wherein the wires lie over the planar surface of the film, and the adhesive layer has a thickness less than the thickness of the wires embedded therein, wherein part of the surfaces of the wires protrudes from the adhesive layer and at least part of the surfaces are covered by a coating consisting of an alloy having a low melting point, to facilitate soldering the wires to the electrically conductive surface and to a first terminal bar.

It is the objective of the present invention to provide conductively efficient and mechanically stable solar cell strings assemblies for use in the production of photovoltaic modules, in particular conductively efficient and mechanically stable shingled and non-shingled solar cell strings and solar cell string assemblies of these.

In a first aspect of the invention the objective is essentially solved by a solar cell string assembly comprising at least two solar cell strings (1), optionally in front-front or front back solar cell configuration with electrically conducting interconnect(s) (3) and serial interconnection in string direction (5), and with a flat adhesive(s) (4), optionally a foil, for adhesively attaching the interconnects) (3) to the solar cells (2) positioned adjacent or shingled in string direction (5), wherein this adhesive (4) extends to at least one solar cell (2) of at least one parallel solar cell string (1) for mechanically bridging and connecting parallel solar cell strings (1) in a solar cell string assembly, wherein the solar cells (2) in parallel connected solar cell strings (1) do not have electrically conductive contact.

This arrangement of parallel linked solar cell strings in the solar cell string assembly has the advantage that the flat adhesive(s) already being functional for attaching the interconnect(s) to the solar cell(s) of one string further spans at least partially the solar cell(s) in a parallel solar cell string, thus providing a highly economical, environmentally protective and mechanically stabilizing means that links the structural stability of one string with that of a parallel string in the string assembly for use in the production of a photovoltaic module.

The term solar cell string assembly, as used herein, is meant to encompass any at least two solar cell strings arranged adjacent and in parallel in string direction with or without a gap or overlap, i.e. negative gap, between strings and with or without vertical offset of the parallel solar cell strings, wherein the parallel solar cell strings are mechanically connected by at least one flat adhesive for fixing the interconnect(s) on one solar cell of one string to a solar cell in the parallel solar cell sting. The term solar cell assembly is understood to refer to an arrangement, layout, array, system, formation, set-up and/or configuration of solar cell strings as described herein.

In one embodiment, the invention relates to a solar cell string assembly for use in a photovoltaic module comprising
(i) at least two solar cell strings (1) of at least two solar cells (2);
(ii) at least one elongated electrically conducting interconnect (3), optionally a wire, ribbon or busbar, extending in string direction (5) for mechanically and electrically connecting adjacent solar cells (2) in string direction for serial interconnection;
(iii) at least one substantially flat adhesive (4), optionally at least two substantially flat adhesives (4), optionally thermoadhesive foil(s), positioned on and adhesive to (a) the at least one elongated interconnect (3) and to (b) at least part of the top or bottom side(s) of each solar cell (2) that comprises the elongated interconnect(s);
wherein the at least one substantially flat adhesive (4), optionally thermoadhesive foil(s), extends to at least one solar cell of at least one parallel solar cell string (1) for mechanically bridging and connecting parallel solar cell strings (1) in the solar cell string assembly, and wherein solar cells (2) in parallel-connected solar cell strings (1) do not have electrically conductive contact.

The term "substantially flat adhesive", as used herein, is meant to be understood to relate to a continuous adhesive having a flat and planar profile as in a sheet, layer or foil, i.e. the adhesive forms a two-dimensional layer with a height much lower than the width and length of the layer, e.g. a height less than 1/10, 1/50, 1/100, 1/1000^{th} of the width and length of the layer. Typical and exemplary heights of substantially flat adhesives for practicing the present invention and for fixing electrically conductive interconnects, e.g. wires, to solar cells are 50 to 300 micrometer. The flat adhesive can be applied to the interconnects and the solar cells as a sheet, layer or foil or, alternatively as a spray coat, subsequently forming a sheet, layer or foil with sufficient structural integrity to remain mechanically intact over the whole area covered in the string assembly of the present invention, thereby connecting parallel solar cells and solar cell strings in the solar cell string assembly of the present invention. It is noted that the terms sheet, layer and foil are used interchangeably to indicate the planar character of the substantially flat adhesive.

The flat adhesive(s) extending from one or more solar cell(s) in one string to one or more solar cell(s) in a parallel string may cover and adhere to part of the solar cells covered or it may cover most if not all of at least one of the solar cells involved.

In one alternative embodiment, the solar cell strings for use in a solar cell string assembly of the present invention may comprise at least one adhesive, optionally thermoadhesive foil(s), that covers at least the full width of a solar cell as measured perpendicular to the string direction. In another alternative embodiment the solar cell string for use in the present invention may comprise at least one adhesive (4), optionally thermoadhesive foil(s), that covers at least the full length of a solar cell as measured parallel to the string direction.

The term "solar cell string", as defined herein, encompasses all mechanical and conductive arrangements of more than one solar cell that generates and transports a photovoltaically generated current along adjacently positioned solar cells in string direction, i.e. in the direction of current flow from the solar cell on one end to the solar cell on the opposite end.

The solar cell string assemblies of the present invention are for use in a photovoltaic module, i.e. for assembling and forming part of a functional photovoltaic module. Optionally, the solar cells for use in the present invention are conventional, e.g. with a semiconductor material positioned between top and bottom surfaces, e.g. anode and cathode materials, i.e. positive and negative electrodes, that may, for example, be formed by metallization or a transparent conductive coating, e.g. a transparent film coating.

It is understood that solar cells in the solar cell strings of the string assembly of the present invention may optionally have front-front or front-back configuration, i.e. top and bottom sides may face each other in the same or opposite polarity, and that the planar sides of two adjacent solar cells in a solar cell string or the assembly are substantially parallel and may optionally overlap partially or not at all, optionally featuring a gap between adjacent solar cells in horizontal or vertical direction. The interconnect(s) is configured in any way that allows for serial connectivity in the strings.

In one embodiment of the solar cell string assembly of the invention, the solar cells in the string are positioned on the same level with a gap between adjacent solar cells, or the solar cells in the string are shingled in string direction with or without partial overlap of solar cells.

The term "shingled in string direction", as used herein, is meant to indicate that consecutive, i.e. neighboring solar cells are vertically offset in string direction. In a string the solar cells may be shingled with or without overlap, meaning that consecutive solar cells partially cover each other, i.e. the upper cell partially shades the vertically offset lower solar cell, or alternatively, the consecutive solar cells are offset vertically but do not form a horizontal gap.

The overlapped edge region of the vertically offset lower solar cell may be optionally minimized to avoid loss of photovoltaic activity due to shading in the resulting solar module.

In one alternative embodiment of the present invention the solar cell strings in the string assembly of the present invention comprise shingled solar cells that overlap at least partially in string direction and the at least one interconnect is not fixated to at least one or both of the solar cells in the overlap region. This alternative has the advantage that the shingled solar cell string maintains some additional mechanical flexibility in the overlap region.

In another alternative embodiment the shingled solar cells do not overlap in the solar cell string. The solar cell string in the string assembly of the invention comprises at least one elongated electrically conducting interconnect, optionally a wire or busbar, extending in string direction for mechanically and electrically connecting the positive and negative electrodes of the shingled or non-shingled solar cells in string direction

In the string assembly of the present invention the at least one interconnect for mechanically and electrically connecting the electrodes of the solar cells may be any material serving said function. For example, the at least one elongated interconnect, optionally a wire, ribbon or bus bar, may further connect all contact structures, optionally contact fingers on each solar cell.

In one optional embodiment the solar cell string in the string assembly of the present inventtion may be one, wherein the height or diameter of the at least one elongated interconnect determines the minimum vertical offset, optionally gap of adjacent solar cells in the solar cell string. In other words, the consecutive neighboring solar cells are vertically separated and mechanically connected only by the interconnect and the mechanical flexibility of interconnect essentially determines the flexibility of the solar cell string.

For example, the at least one interconnect is selected from the group consisting of bus bars, ribbons and metal wires, optionally metal wires coated with solderable material, optionally with Ag-, Cu-, Bi-, In-, Pb-, Sn- and combinations thereof- comprising solder, optionally SnBi- or In-comprising solder. In one non-limiting embodiment, the interconnect mechanically and electrically may contact a conductive layer on the solar cell.

The solar cell string in the solar cell string assembly of the present invention comprises at least one substantially flat adhesive, optionally at least two substantially flat adhesives, optionally thermoadhesive foils, positioned on and adhesive to, thus covering, the at least one elongated interconnect and at the same time at least part of the top or bottom side(s) of each solar cell that comprises the elongated interconnect(s).

It is common general understanding that adhesives on the side(s) of a solar cell, directed towards the sun must be transparent for the sun light to initiate and continue the photovoltaic process in the solar cell.

The substantially flat adhesive(s), for example, adhesive layers or foils, optionally thermoadhesive foils, are made from or comprise a polymer material, optionally selected from the group consisting of duroplasts, optionally EVAs (ethylene vinyl acetates), TPSEs (thermoplastic silicone elastomers), TPUs (thermoplastic polyurethanes), PETs (polyethylene terephthalates), TPOs (thermoplastic polyolefin elastomers), ionomers, thermoplasts; optionally PVBs (polyvinylbutyrals), silicones, polyolefins (PO), PPs (polypropylenes), ionomers; and combinations of thermoduoplasts, optionally a polymer foil thermoadhesive at temperatures in the range of 50 to 250 °C, optionally in the range of 60 to 200 °C, optionally in the range of 75 to 175 °C.

Further aspects of the present invention relate to a photovoltaic module comprising a solar cell string assembly of the present invention as described herein.

In one embodiment, the photovoltaic module of the present invention comprises at least two parallel positioned solar cell strings, the parallel solar cell strings positioned on the same level or shingled perpendicular to the string direction, without electrically conductive contact between parallel solar cells in the parallel strings, optionally having a gap or electrically insulating material between parallel solar cells.

Another aspect encompasses the use of a solar cell string assemblies of the invention as described herein for producing a photovoltaic module.

Further aspects of the present invention relate to a method for producing the solar cell string assemblies as described herein, and to a photovoltaic module comprising the solar cell string assemblies.

In the following the present invention will be illustrated by representative examples and figures, none of which are to be interpreted as limiting the scope of the present invention beyond the appended claims.

### List of reference signs

- (1): solar cell string
- (2): solar cell(s)
- (3): electrically conducting interconnect (e.g. wire, busbar, etc.)
- (4): substantially flat adhesive(s) (optionally thermoadhesive foils)
- (5): string direction in a solar cell string (1)

### Figures

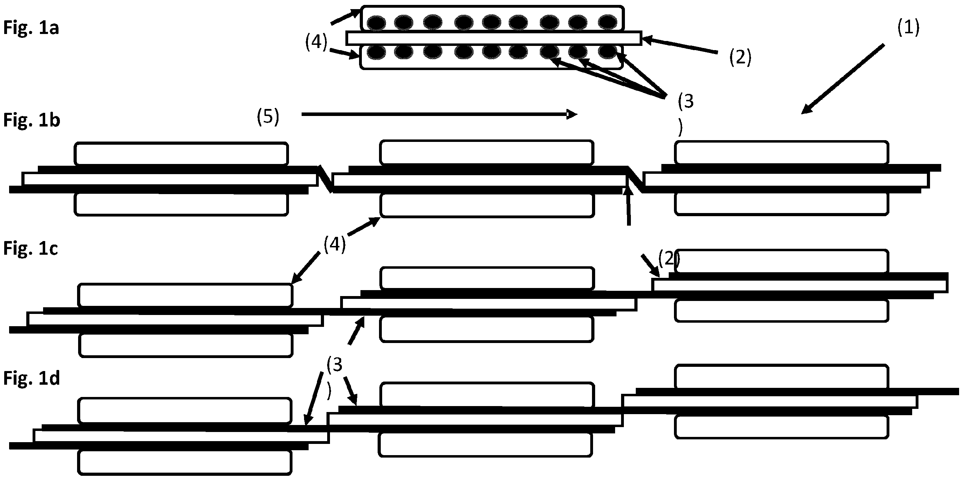

**Fig. 1a** is a schematic cross-sectional view perpendicular to the wire direction on a wired solar cell 2 of the state of the art featuring flat adhesive layers 4 for attaching the wiring 3 to the solar cell's top and lower sides. On the top and the lower sides of the solar cell 2 several wire-like electrically conducting interconnects 3 are enclosed by two substantially flat adhesive layers 4 that position and adhere the interconnects 3 to the sides of opposite polarity. The flat adhesives 4 do not reach to or extend over the sides of the solar cell 2. The interconnects 3 can be implemented, for example, as bus bars, ribbons and metal wires, optionally metal wires coated with solderable material, e.g. as described herein. The adhesive layer 4 on the top side (directed towards the sun in operation) is optionally transparent, whereas the lower side adhesive 4 may optionally not be transparent as it is shaded in operational use anyhow.
**Figs. 1b to 1f** are schematic side views of representative solar cell strings 1, optionally for use in the present invention, encompassing optionally at least two, three or more adjacent solar cells 2 positioned in string direction 5 with or without vertical offset of adjacent solar cells 2, with or without a gap or an overlap, i.e. negative gap, between adjacent solar cells 2 in string direction 5, and with wire-like electrically conducting interconnect(s) 3 attached to the top side of one solar cell 2 having one polarity by the top flat adhesive layer 4 and continuing directly on the same level or via a gap to the lower side of the adjacent solar cell 2 where it is attached to the lower side of opposite polarity by the lower side adhesive 4.
**Figs. 1b** is a schematic side view on a solar cell string 1 encompassing at least three adjacent solar cells 2 positioned in string direction 5 without vertical offset of adjacent solar cells 2, with a gap between adjacent solar cells 2 in string direction 5 and with wire-like electrically conducting interconnect(s) 3 attached to the top side of one solar cell 2 having one polarity by the top flat adhesive 4 and continuing via the gap to the lower side of the adjacent solar cell 2 where it is attached to the lower side of opposite polarity by the lower side adhesive 4.
**Fig. 1c** is a schematic side view on a solar cell string 1 encompassing at least three adjacent solar cells 2 positioned in string direction 5 with a vertical offset of adjacent solar cells 2, with a gap between solar cells 2 in string direction 5 and with wire-like electrically conducting interconnect(s) 3 attached to the top side of one solar cell with one polarity by the top flat adhesive 4 and continuing on the same level across the gap to the lower side of the vertically offset adjacent solar cell 2 where it is attached to the lower side of opposite polarity by the lower side adhesive 4. Each wire-like electrically conducting interconnect(s) 3 between adjacent solar cells 2 maintains the same vertical level.
**Fig. 1d** is a schematic side view similar to that of Fig. 1c but without a gap between adjacent and vertically offset solar cells 2.

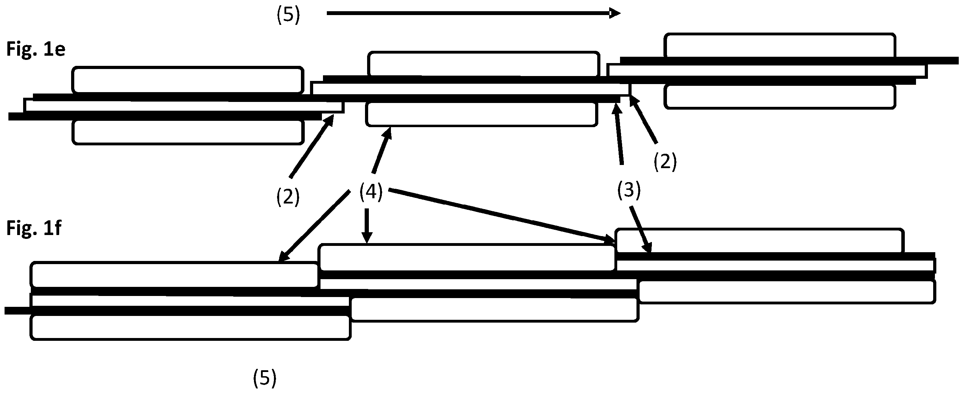

**Fig. 1e** is a schematic side view on a solar cell string 1 encompassing at least three adjacent solar cells 2 positioned in string direction 5 with a vertical offset of adjacent solar cells 2, and shingled with an overlap in string direction 5 of adjacent vertically offset solar cells 2. In the overlap area the wire-like electrically conducting interconnect(s) 3 contacts both the top side of one solar cell 2 and the lower side with opposite polarity of adjacent solar cell 2. Each wire-like electrically conducting interconnect(s) 3 between adjacent solar cells 2 maintains the same vertical level.
**Fig. 1f** is a schematic side view on a solar cell string 1 encompassing at least three adjacent solar cells 2 positioned in string direction 5 with a vertical offset of adjacent, partially overlapping and shingled solar cells 2 similar to Fig. 1e. In this representative embodiment the flat adhesives 4 of solar cells 2 are dimensioned and arranged to contact each other in string direction 5 on the top and/or lower side of the solar cells 2. The adhesives 4 completely extend over and continuously cover the length of the solar cells 2 and the wire-like electrically conducting interconnect(s) 3 in string direction 5 except for the left and right outer ends which are suited for further extension by such solar cell/interconnect/adhesive units. The continuous contacting arrangement of flat adhesives 4 may be implemented on the top and/or lower sides of the solar cells 2 in the string 1 and this embodiment can reduce or prevent negative mechanical or environmental impacts on the solar cell string.

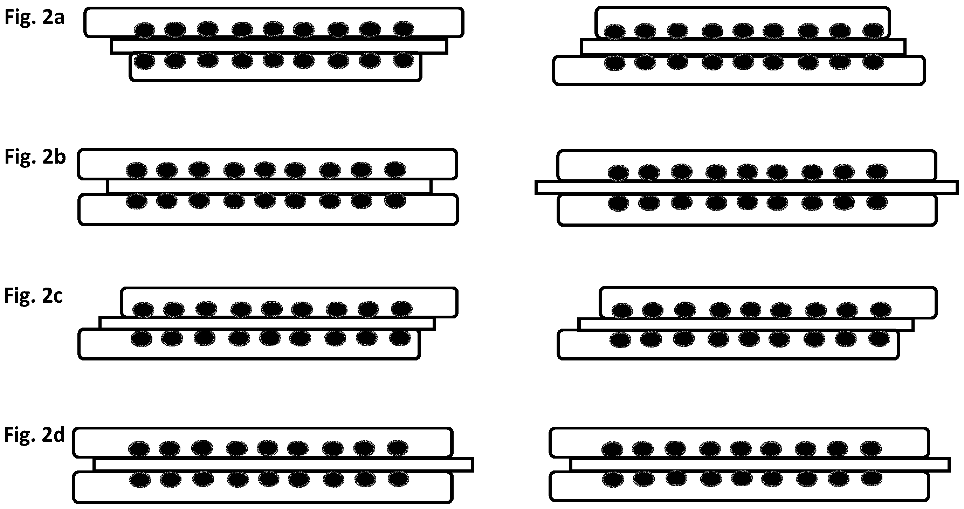

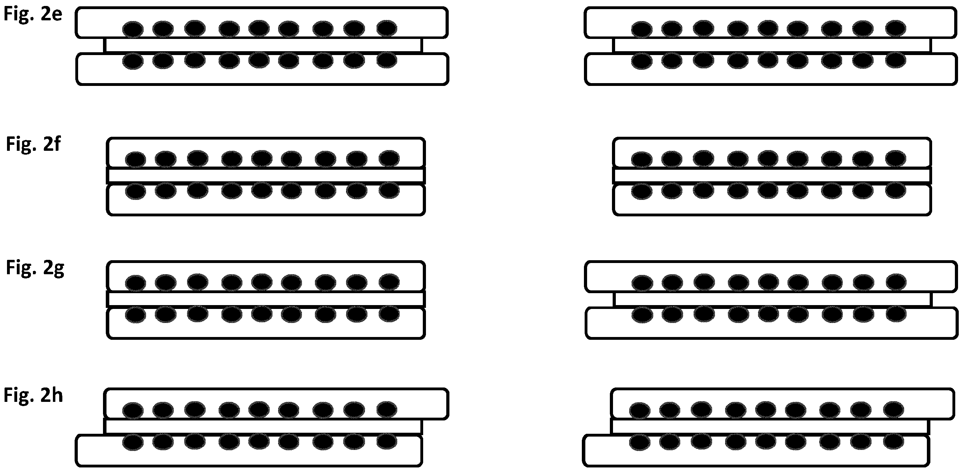

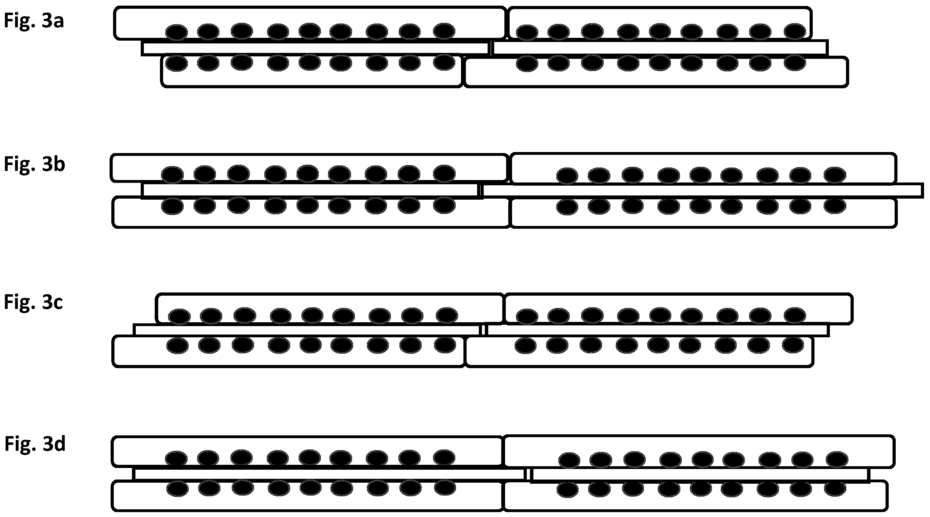

**Figs. 2a to 2d** show pairs of solar cells 2 with interconnects 3 and flat adhesives 4 as cross-sectional side views perpendicular to the wire direction on a solar cell 2. The solar cell pairs are designed to be interlocking when arranged side by side as shown in corresponding **Figs. 3a to 3d****,** which show parallel aligned solar cells 2, each optionally forming part of a separate solar cell string 1 and with the solar cells 2 being positioned parallel on the same level with minimal non-conductive gaps in-between. At least one of the top or lower side adhesives 4 of the parallel solar cells 2 extend to the further solar cell 2, optionally forming part of a parallel solar cell string (1) for mechanically bridging and connecting parallel solar cells and, thus, the corresponding solar cell strings, and wherein the solar cells (2) in parallel connected solar cell strings (1) do not have electrically conductive contact.

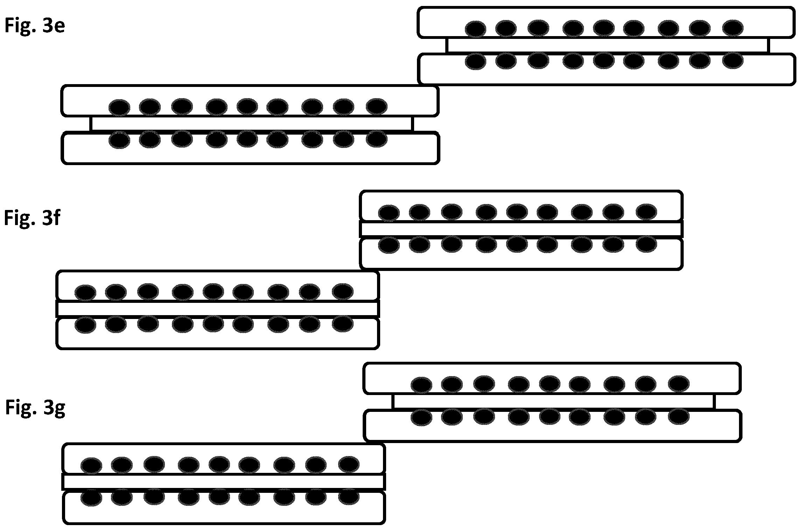

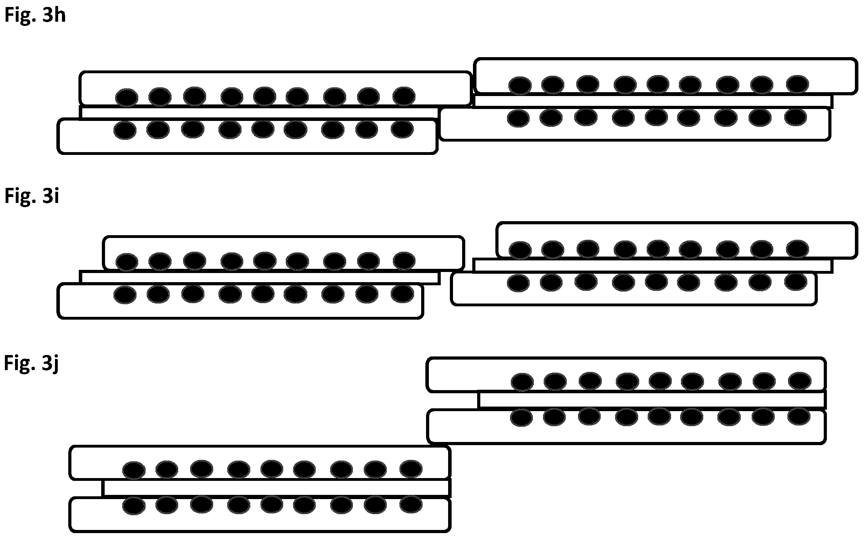

**Figs. 2e to 2h** show pairs of solar cells 2 with interconnects 3 and flat adhesives 4 as cross-sectional side views perpendicular to the wire direction on a solar cell 2. The solar cell pairs have in common that the adhesives on the top and/or lower sides extend at least over the complete width with or without overhangs, thus covering the solar cells completely in width. The pairs can optionally be arranged in parallel and with vertical offset as shown in Figs. 3e to 3h. Figs. 3i and 3j show two further optional parallel arrangements of solar cells with flat adhesives. All embodiments of Figs. 3 to j have in common that at least one substantially flat adhesive 4 extends to at least one solar cell of at least one parallel solar cell string 1 for mechanically bridging and connecting parallel solar cell strings, and wherein solar cells 2 in parallel connected solar cell strings 1 do not have electrically conductive contact.

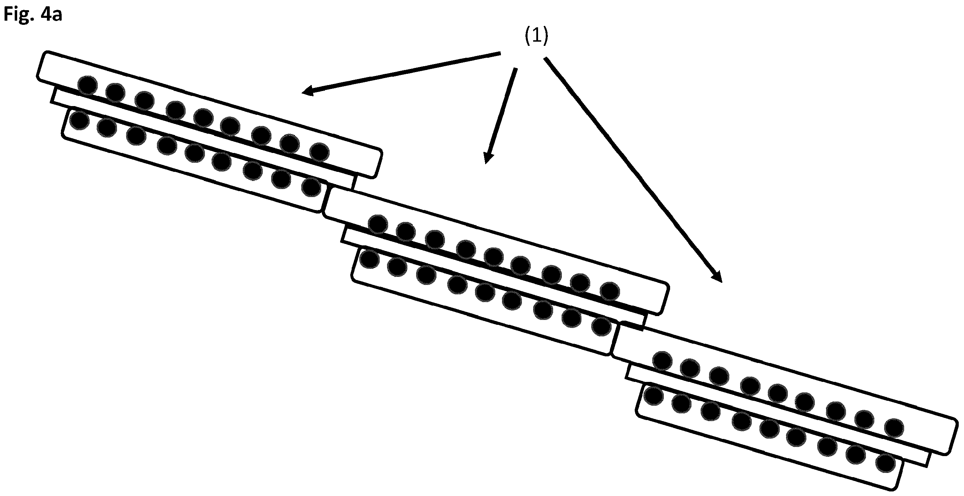

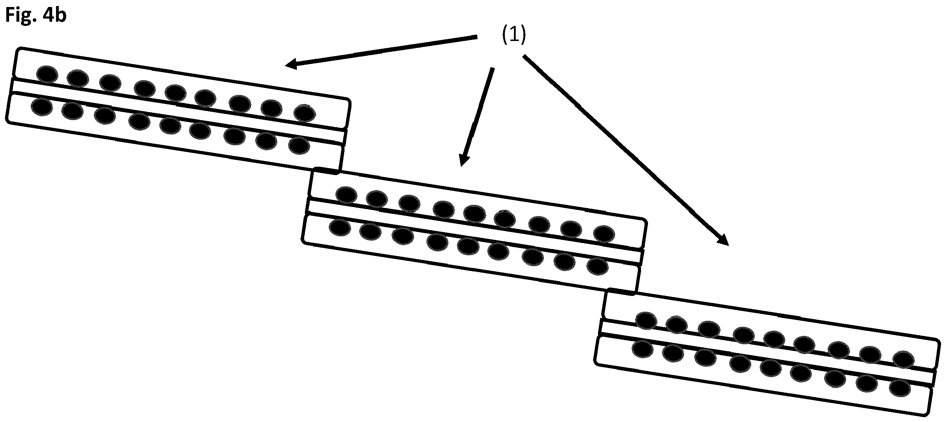

**Figs. 4a** **and** **4b** show representative shingled solar cell string arrangements with three solar cell strings 1 in schematic cross-sectional view perpendicular to the wire direction on a wired solar cell 2. The solar cells 2 overlap and the adhesives on top and bottom sides contact and adhere to each other, thus, providing mechanical stability and protecting the solar cells 2.

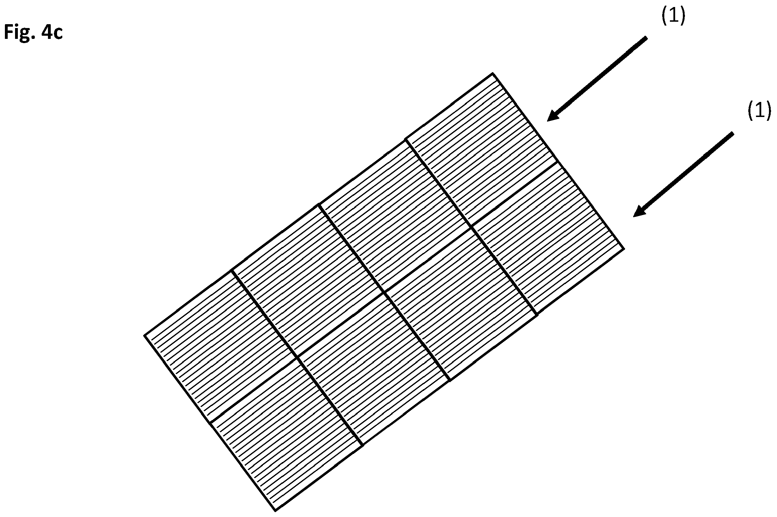

**Fig. 4c** is a top view on two parallel solar cell strings 1 mechanically connected and environmentally protected by overlapping flat adhesives.

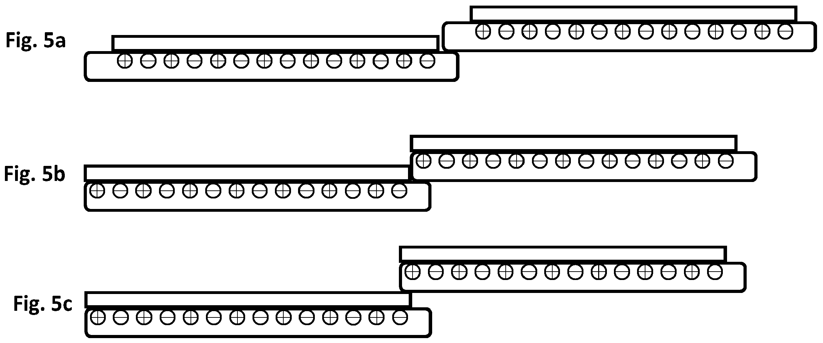

**Figs. 5a, 5b and 5c** show representative shingled solar cell string arrangements for back contacted cells for use in the string assemblies of the present invention with positive and negative contacts and interconnects on the back side of the solar cells (2).

## Claims

1. A solar cell string assembly for use in a photovoltaic module comprising
(i) at least two solar cell strings (1) of at least two solar cells (2);
(ii) at least one elongated electrically conducting interconnect (3), optionally a wire, ribbon or busbar, extending in string direction (5) for mechanically and electrically connecting adjacent solar cells (2) in string direction (5) for serial interconnection;
(iii) at least one substantially flat adhesive (4), optionally at least two substantially flat adhesives (4), optionally thermoadhesive foil(s), positioned on and adhesive to (a) the at least one elongated interconnect (3) and to (b) at least part of the top or bottom side(s) of each solar cell (2) that comprises the elongated interconnect(s);
wherein the at least one substantially flat adhesive (4), optionally thermoadhesive foil(s), extends to at least one solar cell of at least one parallel solar cell string (1) for mechanically bridging and connecting parallel solar cell strings (1) in the solar cell string assembly, and wherein solar cells (2) in parallel-connected solar cell strings (1) do not have electrically conductive contact.

2. The solar cell string assembly of claim 1, wherein the at least one adhesive (4), optionally thermoadhesive foil(s), covers at least the full width of a solar cell as measured perpendicular to the string direction.

3. The solar cell string assembly according to claim 1 or 2, wherein the at least one adhesive (4), optionally thermoadhesive foil(s), covers at least the full length of a solar cell as measured parallel to the string direction.

4. The solar cell string assembly of any of claims 1 to 3, wherein the solar cells (2) in the string (1) are positioned on the same level with a gap between adjacent solar cells (2c), or wherein solar cells (2) are shingled in string direction with or without partial overlap of solar cells (2).

5. The solar cell string assembly of any of claims 1 to 4, wherein the shingled solar cells overlap at least partially in string direction and the at least one interconnect (3) is not fixated to at least one or both of the solar cells in the overlap region.

6. The solar cell string assembly of any of claims 1 to 5, wherein the shingled solar cells do not overlap.

7. The solar cell string assembly of any of claims 1 to 6, wherein the at least one elongated interconnect (3), optionally a wire, ribbon or bus bar, further connects all contact structures, optionally contact fingers, on each solar cell.

8. The solar cell string assembly of any of claims 1 to 7 wherein the height or diameter of the at least one elongated interconnect (3) determines the minimum vertical offset, optionally gap (5) of adjacent solar cells in the shingled solar cell string (1).

9. The solar cell string assembly of any of claims 1 to 8, wherein the at least one interconnect (3) is selected from the group consisting of bus bars, ribbons and metal wires, optionally metal wires coated with solderable material, optionally with Ag-, Cu-, Bi-, In-, Pb-, Sn- and combinations thereof- comprising solder, optionally SnBi- or In-comprising solder.

10. The solar cell string assembly of any of claims 1 to 9, wherein the at least one substantially flat adhesive (4) is a thermoadhesive foil(s) made from or comprising a polymer material, optionally selected from the group consisting of duroplasts, optionally EVAs (ethylene vinyl acetates), TPSEs (thermoplastic silicone elastomers), TPUs (thermoplastic polyurethanes), PETs (polyethylene terephthalates), TPOs (thermoplastic polyfin elastomers), ionomers, thermoplasts; optionally PVBs (polyvinylbutyrals), silicones, PO (polyolefins), PPs (polypropylenes); and combinations of thermoduroplasts, optionally a polymer foil that is thermoadhesive at temperatures in the range of 50 to 250 °C, optionally in the range of 60 to 200 °C, optionally in the range of 75 to 175 °C.

11. A photovoltaic module comprising a solar cell string assembly according to any of claims 1 to 10.

12. The photovoltaic module of claim 11 comprising at least two parallel positioned solar cell strings (1), the parallel solar cell strings (1) positioned on the same level or shingled perpendicular to the string direction (5), without electrically conductive contact between parallel solar cells (2) in the parallel strings (1), optionally having a gap or electrically insulating material between parallel solar cells (2).

13. Use of a solar cell string assembly of any of claims 1 to 9 for producing a photovoltaic module of claim 11 or 12.
